# FASCICULE DE BREVET EUROPEEN

(11) **EP 1 008 176 B1**
(45) Date de publication et mention de la délivrance du brevet: **25.04.2007**
(21) Numéro de dépôt: 98939718.7
(22) Date de dépôt: 20.07.1998
(51) Int. Cl.: H01L 21/48, H01L 23/498

(54) **PROCEDE DE FABRICATION D'UN FILM CONDUCTEUR ANISOTROPE A INSERTS CONDUCTEURS**
HERSTELLUNGSVERFAHREN FÜR EINEN ANISOTROPISCHEN LEITERFILM MIT LEITENDEN EINSATZSTÜCKEN
METHOD FOR MAKING AN ANISOTROPIC CONDUCTIVE COATING WITH CONDUCTIVE INSERTS

(30) Priorité: 22.07.1997 FR 9709263
(43) Date de publication de la demande: 14.06.2000
(73) Titulaire: COMMISSARIAT A L'ENERGIE ATOMIQUE, 75015 Paris (FR)
(72) Inventeur: CAILLAT, Patrice, F-38130 Echirolles (FR); MASSIT, Claude, F-38330 Saint Ismier (FR)
(74) Mandataire: Weber, Etienne Nicolas
(86) Numéro de dépôt international: PCT/FR1998/001586
(87) Numéro de publication internationale: WO 1999/005717

(56) Documents cités:
- EP-A- 0 504 614
- WO-A-91/11833
- US-A- 5 376 226
- US-A- 5 454 161
- US-A- 5 485 039
- "micro machined chip c-4 socket interposer" IBM TECHNICAL DISCLOSURE BULLETIN, vol. 36, no. 6a, juin 1993, pages 129-130, XP002057773 NEW YORK

## Description

### Domaine technique

La présente invention concerne un procédé de fabrication d'un film conducteur anisotrope à inserts conducteurs, au moins une extrémité des inserts comportant une pointe.

Dans le domaine de la microconnectique, il existe trois grandes familles de techniques pour connecter les puces ou circuits intégrés à un substrat d'interconnexion :le microcâblage, la connexion TAB et la technique dite Flip Chip. Dans la technique du microcâblage (appelée "wire bonding" dans la terminologie anglo-saxonne), on utilise des fils d'or ou d'aluminium pour effectuer les connexions. Le TAB (Tape Automated Bonding) utilise un ruban intermédiaire sur lequel un réseau de conducteurs est obtenu par gravure ou croissance chimique. Selon la technique Flip Chip, les plots d'entrées/sorties des puces sont reliés par brasure ou collage sur des plots correspondants d'un substrat. Le Flip Chip par brasure est réalisé par l'intermédiaire de microbossages fusibles (encore appelés billes). Dans la version Flip Chip collé, un film conducteur anisotrope assure en z la conduction électrique et un bon isolement dans le plan xy.

Chacune de ces techniques présente des avantages et des inconvénients. Du point de vue qualité du contact obtenu, le Flip Chip reste, par la limitation de la longueur de connexion obtenue ainsi que par le procédé de brasage lui-même, la voie royale. Par contre, il implique un procédé long et coûteux puisqu'il nécessite couramment deux niveaux de lithographie afin de définir l'emplacement des billes (métallurgie d'accrochage et billes).

Le concept du film conducteur anisotrope, sorte de connecteur universel, en supprimant l'emploi de la lithographie dédiée à chaque application, devient très intéressant. Le principal marché visé actuellement est celui des écrans plats avec le difficile problème de la connexion des puces de commande des pixels sur les écrans à cristaux liquides eux-mêmes. Ce film conducteur est le plus souvent une colle époxy chargée qui, en se réticulant, met en contact en z les charges conductrices et les plots à connecter tout en assurant l'isolement en xy. La fiabilité et la qualité de ces connexions restent pour certaines applications très en dessous du cahier des charges puisque 10% des écrans plats des ordinateurs portables sont recyclés.

### Etat de la technique antérieure

Il est connu d'assurer la connexion électrique entre les plots d'une puce et ceux d'un substrat d'interconnexion, disposés en vis-à-vis, en utilisant une colle conductrice ou un film conducteur anisotrope par contact. Ce type de film ou de colle assure un contact électrique dans la direction z par écrasement de particules conductrices incorporées à la matrice polymère constituant la colle ou le film. Cet écrasement peut être rapporté mécaniquement de l'extérieur, ou obtenu par la réticulation de la colle elle-même qui présente alors un retrait. Dans les deux cas, la résistance de contact est relativement élevée et surtout non reproductible. Dans la plupart des cas, une finition des plots à contacter est nécessaire. Elle est réalisée par dépôt sur les plots d'un revêtement d'or ou d'alliage SnPb. Cette finition améliore la résistance de contact finale obtenue. Les particules peuvent également recevoir une couche superficielle d'or, d'argent ou de nickel.

Une amélioration importante de ce film conducteur anisotrope a été proposée. Elle consiste à utiliser des particules conductrices de nickel qui ont une forme particulière consistant en une sorte de boule pourvue de protubérances acérées. Les protubérances permettent, lors de l'assemblage, de percer la couche d'oxyde présente sur la surface du plot à connecter.

On connaît également les films conducteurs anisotropes à base fusible. Dans ce cas, on utilise des particules fusibles ou recouvertes d'un matériau fusible dans une matrice polymère supportant les hautes températures (par exemple une matrice polyimide). Les plots à connecter sont prévus généralement en aluminium avec une finition brasable (Ni/Au ou alliage SnPb). Par pression et/ou élévation de température à plusieurs centaines de degrés (par exemple ≥ 200°C), le matériau fusible des particules fond, ce qui permet d'établir des contacts électriques entre les plots en regard de la puce et du substrat d'interconnexion. Il faut remarquer qu'il est très difficile d'assurer une brasure des particules à travers le film polymère par simple pression-chauffage puisque le polymère présent en surface peut rapidement empêcher toute soudure correcte des billes entre elles ou sur les plots. Dans la plupart des cas, l'amélioration apportée par cette technique provient de la grande plasticité du matériau fusible qui, en se déformant, permet d'assurer un peu mieux la présence d'un contact électrique.

Une autre technique pour obtenir un film conducteur anisotrope consiste à déposer une couche d'un matériau fusible sur les plots de la puce et une couche de polyimide entre les plots en aluminium du substrat d'interconnexion. La puce et le substrat sont ensuite assemblés, plots à connecter en regard, par application d'une pression et élévation de température (≥ 200°C). L'inconvénient de ce genre de technique est qu'il faut des masques d'ouverture au-dessus des plots pour déposer d'une part le matériau fusible sur la puce et, d'autre part, le matériau polyimide sur le substrat d'interconnexion. On perd donc le côté universel du film conducteur anisotrope.

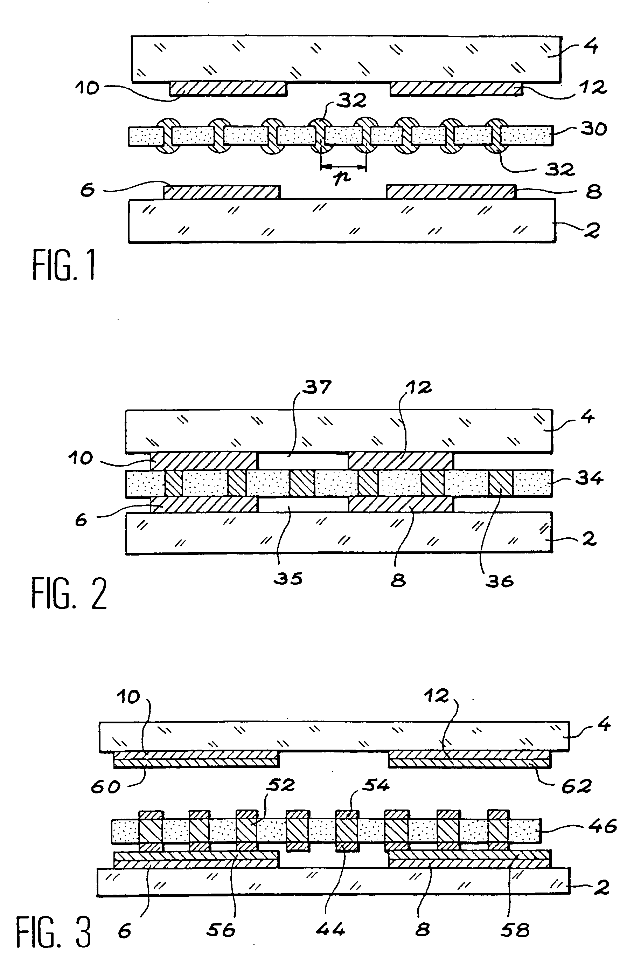

Une autre structure de film conducteur anisotrope est connue sous le sigle VIS (pour "Vertical Interconnection Sheet"). Une telle structure comprend un film isolant pourvu de clous conducteurs traversant l'épaisseur du film. La figure 1 représente une telle structure, dans une version dite à contact "dur". La structure est représentée entre deux éléments à assembler : un substrat d'interconnexion 2, pourvu de plots 6 et 8, et une puce 4 pourvu de plots 10 et 12. La structure doit assurer la liaison électrique entre les plots 6 et 10 d'une part et entre les plots 8 et 12 d'autre part. Elle comprend un film polyimide 30 pourvu de clous débordants 32. Ce type de structure est obtenu par gravure localisée d'une plaque de cuivre sous-jacente au film de polyimide et par croissance électrolytique d'or. L'assemblage de la puce sur le substrat au moyen de cette structure VIS se fait par compression. L'inconvénient de cette structure est que les procédés d'obtention conduisent à des pas p entre les clous relativement importants (de l'ordre de 40 µm). Un autre inconvénient est que la liaison électrique par contact des clous d'or débordants ne permet pas l'adhérence du film polyimide sur la surface de la puce.

Une structure voisine est décrite dans le brevet US-A-5 304 460, illustrée par la figure 2, où on positionne entre la puce 4 et le substrat d'interconnexion 2 un film polymère gravé 34 dans les trous duquel on a évaporé un matériau fusible 36. Ensuite, par compression, les clous 36 en matériau fusible sont écrasés entre les plots 6 et 10 d'une part, 8 et 12 d'autre part. Selon la nature du polymère, on peut avoir un effet adhésif du polymère sur la surface du plot à contacter. Par contre, cet effet adhésif ne s'obtient que sur la surface des plots et pas entre les plots (dans les intervalles 35 et 37 par exemple). En outre, la préparation du polymère dans lequel on évapore un matériau fusible pour réaliser les clous doit être préalablement réalisée sur un support. Il faut ensuite décoller la couche de polymère de ce support, sans enlever le matériau fusible 36, ce qui suppose un procédé à froid. Enfin, la liaison reste de type "contact" car elle est obtenue par écrasement des clous sur les plots. Par conséquent, même avec un matériau fusible, le contact reste médiocre.

Le document FR-A-2 726 397 divulgue un film conducteur anisotrope comportant, comme illustré par la figure 3, une couche de polymère 46 pourvue de clous conducteurs traversants. La partie centrale 52 des clous est constituée d'un matériau dur (par exemple du cuivre, du nickel, un alliage SnPb fusible à haute température). Les extrémités 44 et 54 des clous sont constitués d'un matériau fusible (par exemple un alliage SnPb fusible à basse température). Le film conducteur anisotrope est, sur la figure 3, destiné à assurer les liaisons électriques entre les plots 10 et 12 de la puce 4 et les plots 6 et 8 du substrat d'interconnexion 2. Ces plots sont recouverts de couches d'accrochage 56, 58, 60 et 62 pour braser ou accrocher les matériaux fusibles 44 et 54. Par élévation de température et éventuellement application d'une pression entre la puce 4 et le substrat 2, on assure la connexion électrique de la puce sur le substrat. Les extrémités des clous qui sont en contact avec la couche d'accrochage présente sur les plots s'allient avec celle-ci. Cela se traduit par une diminution de la hauteur des clous entre un plot de la puce et le plot en vis-à-vis du substrat. Cette hauteur est ramenée approximativement à la hauteur de la partie centrale 52 des clous. Pour les autres clous, qui ne sont pas en regard d'une couche d'accrochage, ce phénomène ne se produit pas. Le pas des clous obtenu par la méthode décrite peut être très fin mais, pour avoir un bon contact électrique et conserver l'apport de la brasure des clous, il faut prétraiter les plots à connecter pour les rendre brasables.

Le brevet US-A-5 135 606 divulgue des procédés de réalisation de structures VIS avec des clous de formes adaptées. Les procédés décrits permettent d'élaborer les structures VIS à partir d'un support de base en cuivre. Ils permettent de procurer une forme en pointe aux extrémités débordantes des clous ou inserts. Cependant, la forme en pointe des inserts est obtenue par croissance électrolytique dans une résine comportant des ouvertures coniques. Ce type de procédé ne permet pas d'obtenir des pointes de pentes uniformes car les pentes des motifs de la résine ne sont pas elles-mêmes uniformes, d'une part à cause de l'utilisation d'une gravure chimique et, d'autre part, par l'utilisation d'une insolation à focalisation variable. Par ailleurs, la forme des pointes obtenue par ce type de procédé n'est pas reproductible d'une pointe à l'autre et présente un sommet aplati compte tenu du fait que l'ouverture du masque ne peut être complètement fermée pour permettre le passage de l'électrolyte.

Pour tous ces films conducteurs anisotropes de l'art antérieur, on peut retenir que :
- si l'on utilise des particules ou des clous fusibles, il faudra une finition brasable sur les plots à connecter, donc une couche supplémentaire à déposer sur ceux-ci ;
- si les particules conductrices ont une forme agressive, cette finition n'est pas nécessaire mais, comme la densité de particules conductrices est limitée dans la matrice polymère, des problèmes vont survenir lorsque le pas entre plots à connecter se réduit ou lorsque l'on désire faire passer un courant élevé.

Le brevet US-A-5 135 606 propose des structures à clous débordants de formes variées. Cependant, notamment pour la variante à clous débordants avec pointes, ces structures semblent très difficiles à mettre en oeuvre.

Le document EP-A-0 504 614 propose un procédé de fabrication d'un film conducteur anisotrope.

### Exposé de l'invention

La présente invention propose un procédé de fabrication d'un film conducteur anisotrope avec inserts conducteurs à un pas pouvant être très fin, ces inserts présentant au moins une extrémité en forme de pointe. Le procédé proposé est simple et reproductible. Il est basé sur le transfert par électrolyse, pulvérisation ou évaporation de pointes obtenues sur un substrat, par exemple dans un procédé de gravure chimique.

Le film conducteur anisotrope obtenu par ce procédé permet de monter une structure telle qu'une puce (par exemple un circuit intégré) directement sur le substrat d'interconnexion sans qu'il soit nécessaire de traiter de manière spécifique les plots de la puce. Si les plots du substrat d'interconnexion présentent une couche de finition en cuivre, en or ou en alliage SnPb, il n'est pas nécessaire dans ce cas que les inserts présentent une extrémité en pointe de ce côté. Les plots des puces étant généralement en aluminium sans couche de finition, les inserts présenteront donc leurs pointes de ce côté.

L'invention a donc pour objet un procédé de fabrication d'un film conducteur anisotrope comportant un film isolant percé de trous dans lesquels sont logés des inserts conducteurs qui débordent d'un côté du film isolant en de premières extrémités, à partir d'un substrat dont une face comporte des alvéoles correspondant à la distribution des inserts sur le film isolant, les alvéoles reproduisant en creux la forme des premières extrémités des inserts, comprenant les étapes suivantes :
a) utilisation d'un substrat avec des alvéoles présentant une finition en pointe,
b) réalisation du film isolant au-dessus du substrat avec des trous en regard des alvéoles,
c) réalisation des inserts conducteurs dans les trous et les alvéoles,
d) décollement du film isolant pourvu des inserts conducteurs de son substrat de fabrication qui est réutilisable pour la fabrication d'autres films conducteurs.

Le substrat peut être un monocristal et les alvéoles peuvent être formées par gravure, au moins le fond des alvéoles étant gravé selon des plans cristallographiques déterminés.

Le substrat peut être en silicium. L'étape de gravure peut consister en une attaque chimique selon le plan cristallographique (111) d'un substrat à partir d'une face possédant un plan cristallographique (110).

Entre l'étape a) et l'étape b), on peut effectuer un dépôt d'une couche sacrificielle épousant la face du substrat, le film isolant étant déposé sur la couche sacrificielle. Dans ce cas, l'étape de décollement peut être réalisée par attaque chimique de la couche sacrificielle. Cette attaque chimique de la couche sacrificielle peut être complétée par un effet de capillarité.

La couche sacrificielle étant en matériau conducteur, l'étape c) peut consister à faire croître par électrolyse les inserts conducteurs dans les alvéoles et les trous en utilisant la couche sacrificielle comme électrode.

Le substrat étant conducteur ou semiconducteur dopé, l'étape c) peut consister à faire croître par électrolyse les inserts conducteurs dans les alvéoles et les trous en utilisant le substrat comme électrode.

L'étape c) peut consister à effectuer dans les alvéoles et dans les trous, une pulvérisation ou une évaporation du ou des matériaux conducteurs devant former les inserts. Dans ce cas, l'étape de pulvérisation ou d'évaporation peut consister d'abord à positionner un masque pourvu de trous, à une distance déterminée du film isolant, les trous du masque étant alignés avec les alvéoles du substrat et les trous du film et ayant un diamètre initial déterminé,puis à pulvériser ou à évaporer, par les trous du masque, le ou les matériaux conducteurs formant les inserts conducteurs. Ledit diamètre initial déterminé des trous du film peut être tel qu'à cause de la réduction de ce diamètre initial due à la pulvérisation ou à l'évaporation, les secondes extrémités des inserts se terminent également en pointes.

L'étape d) de décollement peut utiliser des forces mécaniques.

L'étape a) et l'étape b) peuvent consister d'abord à déposer le film isolant au-dessus du substrat, éventuellement recouvert d'une couche sacrificielle, dont la face ne comporte pas encore les alvéoles,puis à positionner un masque pourvu de trous selon un motif correspondant à la distribution des inserts dans le film, ensuite à graver à travers les trous du masque d'une part le film isolant, et éventuellement la couche sacrificielle, pour y former les trous et d'autre part le substrat pour y former les alvéoles ,enfin à éliminer le masque. Dans ce cas, si les inserts sont réalisés par électrolyse, après gravure des trous dans le film isolant et avant élimination du masque, un dépôt d'une couche de matériau conducteur épousant les zones gravées du substrat peut être réalisé.

Avantageusement, les premières extrémités des inserts conducteurs sont réalisées en un matériau dur. Ceci permet à ces extrémités de pouvoir percer la couche d'oxyde recouvrant le plot à connecter. Les inserts peuvent être entièrement réalisés dans ce matériau dur. A titre de variante, seule la partie débordante des inserts peut être réalisée en matériau dur.

Le film isolant peut être un film de polymère thermoplastique ou un film multicouche dont les couches extérieures sont thermoplastiques. Ceci permet de lui conférer une fonction autocollante lors de l'assemblage. Dans le cas contraire, il faudra le pourvoir d'une couche de colle avant l'assemblage.

Les trous gravés dans le film isolant peuvent être de section inférieure à la section des alvéoles sur ladite face du substrat. Ceci permet d'obtenir un effet d'enchâssement des inserts sur le film isolant.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- les figures 1 à 3, déjà décrites, représentent des liaisons par film conducteur anisotrope selon l'art antérieur,
- les figures 4A à 4F illustrent une première variante du procédé de fabrication d'un film conducteur anisotrope selon la présente invention,
- la figure 5 est une vue de dessus et en coupe selon l'axe V-V de la figure 4E d'un insert et de son environnement immédiat,
- les figures 6A et 6B illustrent une deuxième variante du procédé de fabrication d'un film conducteur anisotrope selon la présente invention,
- les figures 7A à 7F, illustrent une troisième variante du procédé de fabrication d'un film conducteur anisotrope selon la présente invention.

### Description détaillée de modes de réalisation de l'invention

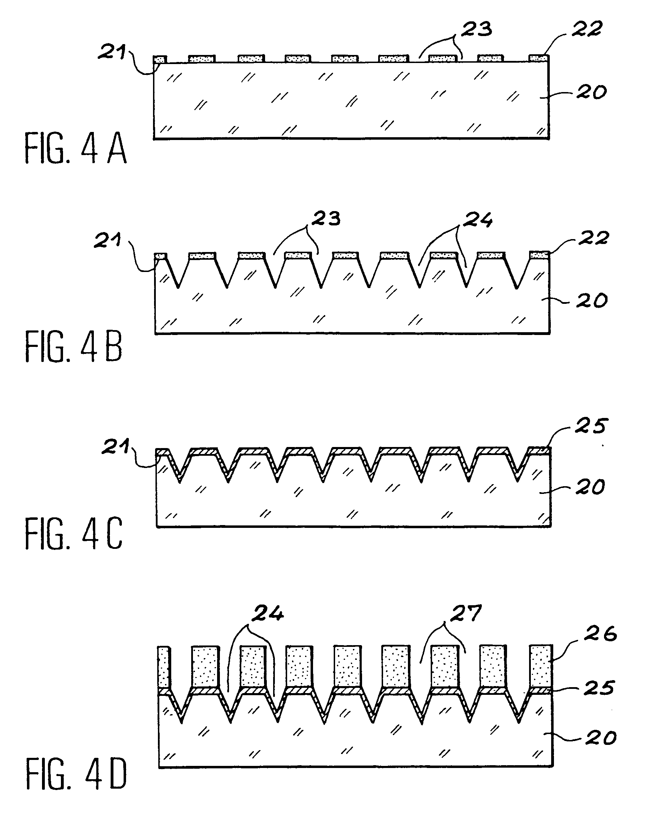

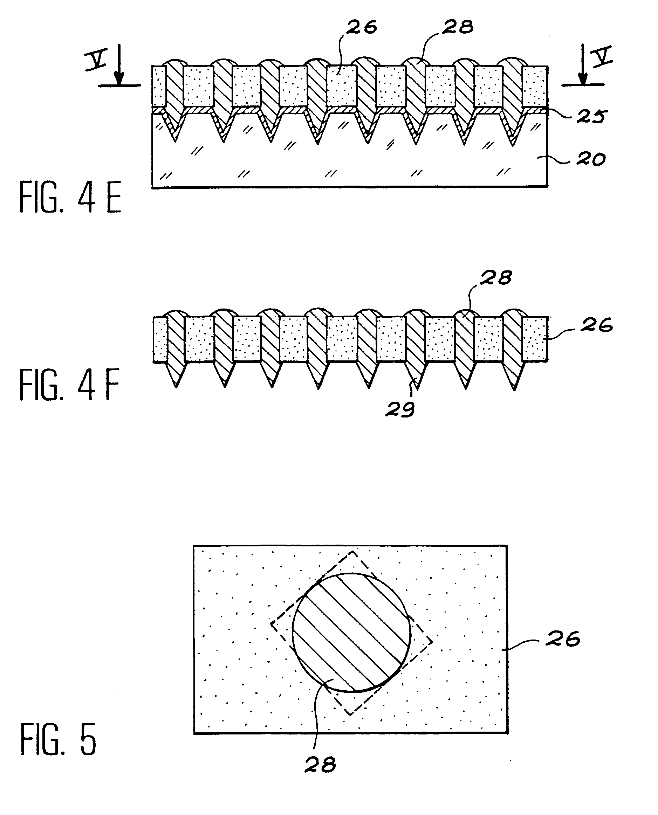

Un procédé de fabrication d'un film conducteur anisotrope selon la présente invention est illustré par les figures 4A à 4F.

La première étape de ce procédé consiste à graver par exemple un substrat en silicium 20. Pour cela, la face plane 21 du substrat 20, de plan cristallographique (110), est recouverte d'un masque 22 en nitrure de silicium ou en or. Par une technique de lithographie, le masque 22 est gravé de façon que la face 21 du substrat 20 apparaisse par des ouvertures 23 (figure 4A). Les parties apparentes de la face plane 21 reçoivent alors une gravure chimique (par exemple en utilisant du KOH) selon les plans cristallographiques (111). On obtient des alvéoles 24 de section carrée (figure 4B).

Ce qui subsiste du masque 22 est alors enlevé et on procède au dépôt d'une couche sacrificielle, par exemple conductrice, 25 sur la face 21 gravée du substrat 20 (figure 4C). Cette couche 25 peut être réalisée en Cu, Ti, Ni, ou SnPb. Son épaisseur est telle (par exemple 0,1 à 3 µm) qu'elle épouse le profil de la face 21 gravée.

Une couche de polymère 26 (par exemple une couche de polyimide de 10 µm d'épaisseur) est déposée sur la couche métallique 25. Par une technique de photolithographie, cette couche 26 est gravée pour y former des trous circulaires 27 alignés avec les alvéoles 24 du substrat 20 (figure 4D).

Par croissance électrolytique, en une étape, en se servant de la couche métallique 25 comme électrode, on constitue les inserts métalliques 28 depuis le fond des alvéoles 24 jusque sur la face supérieure de la couche de polymère 26, en passant par les trous 27. Le métal constituant les inserts 28 peut être du nickel ou du cuivre (figure 4E).

La dernière étape consiste à graver chimiquement la couche métallique 25 afin d'obtenir le décollement du film isolant 26 pourvu des inserts 28 (figure 4F).

La gravure du substrat de silicium a été menée de façon que les alvéoles gravées soient de forme pyramidale à section carrée. Les pointes 29 des inserts 28 présentent donc également la même forme. Les trous 27 réalisés dans le film isolant 26 sont de section circulaire. La section des trous 27 étant inférieure à la section des alvéoles 24 au niveau de la face 21 du substrat 20, les inserts se trouvent enchâssés dans le film isolant 26. C'est ce que montre la figure 5.

Une fois qu'un premier film conducteur anisotrope a été réalisé selon ce procédé, le décollement du film laisse un substrat gravé, réutilisable pour la fabrication d'un nouveau film.

Un autre procédé de fabrication d'un film conducteur anisotrope selon la présente invention va maintenant être décrit. Jusqu'à l'ouverture du film isolant, ce procédé comporte les mêmes étapes que le procédé décrit précédemment. On ne décrira donc que les étapes postérieures à celles qui ont abouti à la structure représentée à la figure 4D. Ensuite, sur cette structure, on positionne un masque 15, pourvu de trous 16, à une distance déterminée du film isolant 26. Les trous 16 du masque 15 correspondent aux alvéoles du substrat 26 et sont alignés avec les alvéoles. La distance d séparant le masque 15 du film isolant 26 et le diamètre des trous 16 sont choisis de manière à obtenir les inserts désirés.

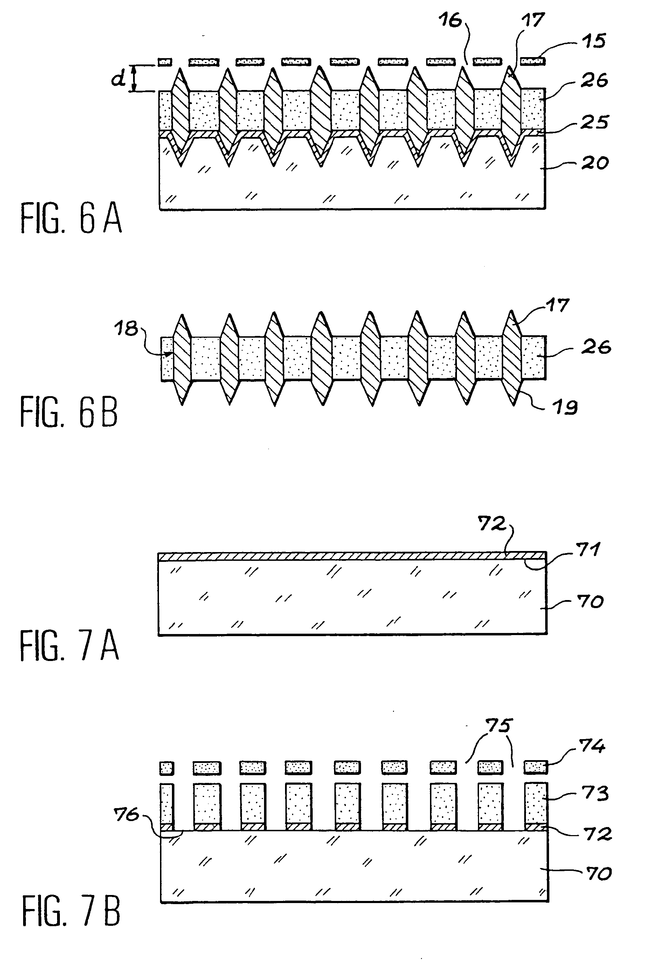

A travers les trous 16 du masque 15, on pulvérise ou on évapore le métal destiné à constituer les inserts (nickel ou cuivre par exemple). Le diamètre des trous 16 se réduit au fur et à mesure du dépôt métallique. Ceci conduit, si la distance d et le diamètre des trous 16 sont correctement choisis (par le calcul ou l'expérimentation), à donner aux extrémités 17 des inserts situés près du masque 15 une forme en pointe (figure 6A).

On procède ensuite au décollement du film isolant 26 par gravure chimique de la couche conductrice 25, par exemple grâce à l'acide fluorhydrique. La figure 6B montre le résultat obtenu. Le film conducteur anisotrope comporte des inserts 18 présentant de premières extrémités 19 reproduisant la forme des alvéoles du substrat et de deuxièmes extrémités 17 en forme de pointes mais de section circulaire.

Un autre procédé de fabrication d'un film conducteur anisotrope selon la présente invention va enfin être décrit en référence aux figures 7A à 7F. On part d'un substrat 70 en silicium possédant une face plane 71 de plan cristallographique (110). Une couche de matériau conducteur 72 (par exemple une couche de Cu, Ti, Ni ou SnPb de 0,1 à 3 µm d'épaisseur) est déposée sur la face plane 71 (figure 7A).

On dépose ensuite, sur la couche 72, une couche de polymère 73 (par exemple une couche de polyimide de 10 µm d'épaisseur). Un masque 74 est positionné au-dessus de la couche de polymère 73. Ce masque 74 est pourvu de trous 75 selon un motif correspondant à la distribution désirée des inserts. On procède à une opération de gravure au travers des trous 75 qui permet de mettre à nu les zones 76 du substrat correspondant aux trous 75 du masque 74 (figure 7B).

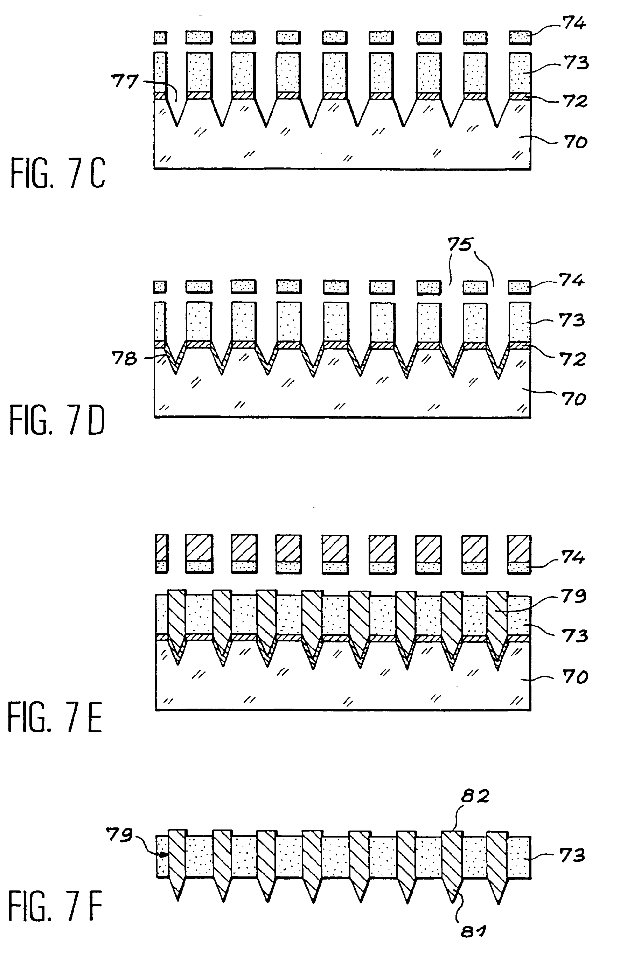

Le substrat 70 est alors gravé chimiquement selon les plans cristallographiques (111). On obtient des alvéoles 77 de section carrée (figure 7C).

Ensuite, au travers des trous 75 du masque 74, on dépose une autre couche métallique 78 sur le substrat 70. On obtient ainsi sur cette face du substrat un revêtement métallique continu épousant la face gravée du substrat 70 et constitué des couches 72 et 78 (figure 7D).

Les inserts 79 peuvent être alors constitués par évaporation ou pulvérisation de métal (par exemple du nickel ou du cuivre) au travers des trous du masque 74, le métal se déposant également sur ce masque 74 (figure 7E). De même, on peut utiliser ce fond métallique 72 et 78 pour faire croître par électrolyse les inserts comme décrit précédemment (combinaison).

Le masque est ôté et le film isolant 73 est décollé comme précédemment. La figure 7F montre le résultat obtenu. Le film conducteur anisotrope comporte des inserts 79 présentant de premières extrémités 81 reproduisant la forme des alvéoles du substrat et de deuxième extrémités plates 82.

Selon ce dernier procédé le masque 74 est indépendant du film polymère 73. Il est simplement rapporté dessus. On peut également le construire sur la couche de polyimide avec des techniques de microélectronique classique (par exemple une couche d'or résistant à la gravure du KOH).

Une fois qu'un premier film conducteur anisotrope a été réalisé selon ce procédé, le décollement du film laisse un substrat gravé. Ce substrat gravé est réutilisable par exemple selon le procédé décrit plus haut en relation avec les figures 4A à 4F. Ce substrat gravé est aussi réutilisable avec le dernier procédé décrit. En déposant une couche métallique (remplaçant les couches 72 et 78) sur le substrat gravé, puis une couche de polymère (remplaçant la couche 73). En replaçant le masque 74 pourvu des trous 75, on grave la couche de polymère pour obtenir la situation représentée à la figure 7D.

En utilisant la gravure préférentielle du silicium, on obtient une pointe parfaitement définie et d'une grande agressivité. Le problème de la qualité électrique du contact est résolu avec, sur un plot d'aluminium, des résistances de contact inférieurs à 20 mΩ facilement réalisables.

Dans le cas de l'utilisation d'un polymère non thermoplastique pour constituer le film isolant, les pointes des inserts permettent de garder un léger espacement entre le film et la puce à connecter, ce qui laisse un film de colle sur toutes les surfaces à mettre en contact et donc une excellente tenue mécanique.

Les procédés décrits plus haut permettent de descendre très bas dans la taille des inserts : 1 à 2 µm de diamètre pour un pas de 4 à 5 µm. ceci permet l'interconnexion de puces ayant des entrées/sorties à un pas très faible.

Les inserts obtenus par ces procédés peuvent être enchâssés dans le film isolant, ce qui assure une bonne cohésion de l'ensemble.

Le substrat de silicium constitue un "moule" qui permet d'avoir toutes les pointes à niveau. En effet, on commence à fabriquer les inserts par les pointes contrairement à certains procédés de l'art connu où des pointes étaient rajoutées au corps de l'insert. On évite ainsi les inhomogénéités dues aux opérations intermédiaires d'obtention des corps des inserts.

Le procédé selon l'invention peut aussi combiner les modes de réalisation décrits ci-dessus. En particulier, les inserts conducteurs peuvent être réalisés en partie par électrolyse et finis par pulvérisation ou évaporation, notamment pour obtenir des deuxièmes extrémités en pointes.

Contrairement aux techniques VIS de l'art antérieure, le principe de l'invention permet d'une part d'avoir des inserts dont les extrémités sont en pointes et d'autre part de réutiliser le substrat, qui n'est pas sacrifié au cours de la réalisation du film conducteur, pour d'autres films conducteurs.

## Revendications

1. Procédé de fabrication d'un film conducteur anisotrope comportant un film isolant (26, 73) percé de trous (27) dans lesquels sont logés des inserts conducteurs (28,18,79) qui débordent d'un côté du film isolant en de premières extrémités (29,19,81), à partir d'un substrat (20,70) dont une face comporte des alvéoles (24,77) correspondant à la distribution des inserts sur le film isolant, les alvéoles reproduisant en creux la forme des premières extrémités des inserts, comprenant les étapes suivantes :
a) utilisation d'un substrat (20,70) avec des alvéoles (24,77) présentant une finition en pointe,
b) réalisation du film isolant (26,73) au-dessus du substrat (20,70) avec des trous (27) en regard des alvéoles,
c) réalisation des inserts conducteurs (28,18,79) dans les trous et les alvéoles,
d) décollement du film isolant (26,73) pourvu des inserts conducteurs de son substrat de fabrication qui est réutilisable pour la fabrication d'autres films conducteurs.

2. Procédé selon la revendication 1, **caractérisé en ce que** le substrat est un monocristal et **en ce que** les alvéoles sont formées par gravure, au moins le fond des alvéoles étant gravé selon des plans cristallographiques déterminés.

3. Procédé selon la revendication 2, **caractérisé en ce que** le substrat est en silicium.

4. Procédé selon la revendication 3, **caractérisé en ce que** l'étape de gravure consiste en une attaque chimique selon le plan cristallographique (111) d'un substrat (20,70) à partir d'une face (21,71) possédant un plan cristallographique (110).

5. Procédé selon l'une quelconque des revendications 1 à 4, **caractérisé en ce qu'**entre l'étape a) et l'étape b), on effectue un dépôt d'une couche sacrificielle épousant la face du substrat, le film isolant étant déposé sur la couche sacrificielle.

6. Procédé selon l'une quelconque des revendications 1 à 5, **caractérisé en ce que** l'étape b) consiste à déposer un film isolant au-dessus du substrat et à graver ledit film pour y former des trous alignés avec les alvéoles du substrat et destinés à loger les inserts conducteurs.

7. Procédé selon la revendication 5, **caractérisé en ce que** la couche sacrificielle étant en matériau conducteur, l'étape c) consiste à faire croître par électrolyse les inserts conducteurs dans les alvéoles et les trous en utilisant la couche sacrificielle comme électrode.

8. Procédé selon l'une quelconque des revendications 1 à 6, **caractérisé en ce que** le substrat étant conducteur ou semiconducteur dopé, l'étape c) consiste à faire croître par électrolyse les inserts conducteurs dans les alvéoles et les trous en utilisant le substrat comme électrode.

9. Procédé selon l'une quelconque des revendications 1 à 6 **caractérisé en ce que** l'étape c) consiste à effectuer dans les alvéoles et dans les trous, une pulvérisation ou une évaporation du ou des matériaux conducteurs devant former les inserts.

10. Procédé selon la revendication 9, **caractérisé en ce que** l'étape de pulvérisation ou d'évaporation consiste :
- à positionner un masque pourvu de trous, à une distance déterminée du film isolant, les trous du masque étant alignés avec les alvéoles du substrat et les trous du film et ayant un diamètre initial déterminé,
- à pulvériser ou à évaporer, par les trous du masque, le ou les matériaux conducteurs formant les inserts conducteurs.

11. Procédé selon la revendication 10, **caractérisé en ce que** ledit diamètre initial déterminé des trous du film est tel qu'à cause de la réduction de ce diamètre initial due à la pulvérisation ou à l'évaporation, les secondes extrémités des inserts se terminent également en pointes.

12. Procédé selon la revendication 5, **caractérisé en ce que** l'étape d) de décollement est réalisée par attaque chimique de la couche sacrificielle.

13. Procédé selon la revendication 12, **caractérisé en ce que** l'attaque chimique de la couche sacrificielle est complétée par un effet de capillarité.

14. Procédé selon l'une quelconque des revendications 1 à 13, **caractérisé en ce que** l'étape d) de décollement utilise des forces mécaniques.

15. Procédé selon l'une quelconque des revendications précédentes, **caractérisé en ce que** l'étape a) et l'étape b) consistent :
- à déposer le film isolant au-dessus du substrat, éventuellement recouvert d'une couche sacrificielle, dont la face ne comporte pas encore les alvéoles,
- à positionner un masque pourvu de trous selon un motif correspondant à la distribution des inserts dans le film,
- à graver à travers les trous du masque d'une part le film isolant, et éventuellement la couche sacrificielle, pour y former les trous et d'autre part le substrat pour y former les alvéoles ,
- à éliminer le masque.

16. Procédé selon la revendication 15, **caractérisé en ce que** les inserts étant réalisés par électrolyse, après gravure des trous dans le film isolant et avant élimination du masque, un dépôt d'une couche de matériau conducteur épousant les zones gravées du substrat est réalisé.

17. Procédé selon l'une quelconque des revendications 1 à 16, **caractérisé en ce que** les premières extrémités (29,19,81) des inserts conducteurs (28,18,79) sont réalisées en un matériau dur.

18. Procédé selon l'une quelconque des revendications 1 à 17, **caractérisé en ce que** ledit film isolant (26,73) est un film de polymère thermoplastique.

19. Procédé selon l'une quelconque des revendications 1 à 18, **caractérisé en ce que** les trous (27) gravés dans le film isolant (26) sont de section inférieure à la section des alvéoles (24) sur ladite face (21) du substrat (20).

## Claims

1. Process for manufacturing an anisotropic conducting film comprising an insulating film (26, 73) in which holes (27) are formed, conducting inserts (28, 18, 79) being located in the holes, the first ends (29, 19, 81) of the inserts projecting from one side of the insulating film, from a substrate (20, 70) in which compartments (24, 77) are formed on one surface, corresponding to the distribution of inserts on the insulating film, the shape of the compartments being complementary to the shape of the first ends of the inserts, comprising the following steps:
a) use of a substrate (20, 70) with compartments (24, 77) with a tipped finish,
b) production of the insulating film (26, 73) above the substrate (20, 70) with holes (27) facing the compartments,
c) production of conducting inserts (28, 18, 79) in the holes and the compartments,
d) separation of the insulating film (26, 73) in which the conducting inserts are formed from its manufacturing substrate, which is reusable for manufacturing other conducting films.

2. Process according to claim 1, **characterized in that** the substrate is a single crystal and **in that** the compartments are formed by etching, at least the bottom of the compartments being etched along determined crystallographic planes.

3. Process according to claim 2, **characterized in that** the substrate may be made of silicon.

4. Process according to claim 3, **characterized in that** the etching step consists of chemical etching along the crystallographic plane (111) of a substrate (20, 70) starting from a face (21, 71) with a crystallographic plane (110).

5. Process according to any one of claims 1 to 4, **characterized in that** a sacrificial layer matching the surface of the substrate is deposited between step a) and step b), the insulating film being deposited on the sacrificial layer.

6. Process according to any one of claims 1 to 5, **characterized in that** step b) consists of depositing an insulating film above the substrate and etching the said film to form holes in line with the compartments in the substrate and that will contain the conducting inserts.

7. Process according to claim 5, **characterized in that** the sacrificial layer is made of a conducting material, step c) may consist of making the conducting inserts grow by electrolysis in the compartments and the holes, using the sacrificial layer as an electrode.

8. Process according to any one of claims 1 to 6, **characterized in that** the substrate is a conducting or doped semiconductor material, step c) may consist of making the conducting inserts grow by electrolysis in the compartments and the holes using the substrate as an electrode.

9. Process according to any one of claims 1 to 6, **characterized in that** step c) consists of atomization or evaporation of the conducting material(s) that will form the inserts, in the compartments and the holes.

10. Process according to claim 9, **characterized in that** the atomization or evaporation step consists of:
- positioning a mask provided with holes at a given distance from the insulating film, the holes in the mask being in line with the compartments in the substrate and the holes in the film, and with a determined initial diameter,
- atomizing or evaporating the conducting material(s) forming the conducting inserts, through the holes in the mask.

11. Process according to claim 10, **characterized in that** the said determined initial diameter of the holes in the film is such that the second ends of the inserts also terminate in tips, due to the reduction in the initial diameter due to atomization or evaporation.

12. Process according to claim 5, **characterized in that** the separation step d) is made by chemical etching of the sacrificial layer.

13. Process according to claim 12, **characterized in that** the chemical etching of the sacrificial layer is complemented by a capillarity effect.

14. Process according to any one of claims 1 to 13, **characterized in that** the separation step d) uses mechanical forces.

15. Process according to any one of the previous claims, **characterized in that** step a) and step b) consist of:
- depositing the insulating film on top of the substrate, possibly covered with a sacrificial layer, in which compartments have not yet been formed on the surface,
- positioning a mask in which holes are formed in a pattern corresponding to the distribution of inserts in the film,
- etching firstly the insulating film and possibly the sacrificial layer to form holes in it, and secondly the substrate to form compartments in it, through the holes in the mask,
- eliminating the mask.

16. Process according to claim 15, **characterized in that** the inserts are made by electrolysis, a layer of conducting material matching the etched areas of the substrate is deposited after the holes have been etched in the insulating film and before the mask is eliminated.

17. Process according to any one of claims 1 to 16, **characterized in that** the first ends (29, 19, 81) of the conducting inserts (28, 18, 79) are made from a hard material.

18. Process according to any one of claims 1 to 17, **characterized in that** the said insulating film (26, 73) is a thermoplastic polymer film.

19. Process according to any one of claims 1 to 18, **characterized in that** the cross-section of the holes (27) etched in the insulating film (26) may be smaller than the cross-section of the compartments (24) on the said surface (21) of the substrate (20).

## Patentansprüche

1. Verfahren zur Herstellung eines anisotropen elektrisch leitenden Films, der umfasst einen isolierenden Film (26, 73), der von Löchern (27) durchbohrt ist, in denen Leiter-Inserts (28, 18, 79) angeordnet sind, die über eine Seite des isolierenden Films in Form von ersten Enden (Spitzen) (29, 19, 81) überstehen, bei dem man von einem Substrat (20, 70) ausgeht, das auf einer Seite (Oberfläche) Alveolen (24, 77) aufweist, die der Verteilung der Inserts in dem isolierenden Film entsprechen, wobei die Alveolen Ausnehmungen darstellen, die der Form der ersten Enden (Spitzen) der Inserts entsprechen, wobei das Verfahren die folgenden Stufen umfasst:
a) Verwendung eines Substrats (20, 70) mit Alveolen (24, 77), die ein punktförmiges (spitzes) Ende aufweisen,
b) Aufbringen des isolierenden Films (26, 73) auf das Substrat (20, 70), das den Alveolen gegenüberliegende Löcher (27) aufweist,
c) Bildung der Leiter-Inserts (28, 18, 79) in den Löchern und den Alveolen,
d) Abziehen des isolierenden Films (26, 73), der mit Leiter-Inserts ausgestattet ist, von seinem Herstellungs-Substrat, das für die Herstellung von anderen (weiteren) Leiter-Filmen wieder verwendbar ist.

2. Verfahren nach Anspruch 1, **dadurch gekennzeichnet, dass** das Substrat ein Monokristall ist und dass die Alveolen durch Ätzen erzeugt werden, wobei mindestens der Boden der Alveolen entlang festgelegter kristallographischer Ebenen geätzt wird.

3. Verfahren nach Anspruch 2, **dadurch gekennzeichnet, dass** das Substrat aus Silicium besteht.

4. Verfahren nach Anspruch 3, **dadurch gekennzeichnet, dass** das Ätzen darin besteht, dass man die kristallographische Ebene (111) eines Substrats (20, 70) chemisch ätzt (beizt), ausgehend von einer Fläche (21,71), die eine kristallographische Ebene (110) aufweist.

5. Verfahren nach einem der Ansprüche 1 bis 4, **dadurch gekennzeichnet, dass** zwischen der Stufe (a) und der Stufe (b) eine sich an die Oberfläche des Substrats anpassende (anschmiegende) Opferschicht abgeschieden wird, wobei der isolierende Film auf die Opferschicht aufgebracht wird.

6. Verfahren nach einem der Ansprüche 1 bis 5, **dadurch gekennzeichnet, dass** die Stufe (b) darin besteht, dass auf dem Substrat ein isolierender Film abgeschieden wird und der genannte Film geätzt wird, um darin Löcher zu erzeugen, die auf die Alveolen des Substrats ausgerichtet sind und in welchen die Leiter-Inserts angeordnet werden sollen.

7. Verfahren nach Anspruch 5, **dadurch gekennzeichnet, dass** dann, wenn die Opferschicht aus einem elektrisch leitenden Material besteht, die Stufe (c) darin besteht, dass die Leiter-Inserts durch Elektrolyse in die Alveolen und in die Löcher hineinwachsen gelassen werden, wobei man die Opferschicht als Elektrode verwendet.

8. Verfahren nach einem der Ansprüche 1 bis 6, **dadurch gekennzeichnet, dass** dann, wenn das Substrat ein elektrischer Leiter oder ein dotierter Halbleiter ist, die Stufe (c) darin besteht, dass man die Leiter-Inserts in die Alveolen und in die Löcher hineinwachsen lässt, wobei man das Substrat als Elektrode verwendet.

9. Verfahren nach einem der Ansprüche 1 bis 6, **dadurch gekennzeichnet, dass** die Stufe (c) darin besteht, dass man vor der Bildung der Inserts ein oder mehrere elektrisch leitende Materialien durch Sputtern oder Aufdampfen in die Alveolen und in die Löcher einbringt.

10. Verfahren nach Anspruch 9, **dadurch gekennzeichnet, dass** die Sputter- oder Aufdampfungsstufe darin besteht, dass man:
- eine mit Löchern versehene Maske in einem vorgegebenen Abstand von einem isolierenden Film anordnet, wobei die Löcher der Maske auf die Alveolen des Substrats und die Löcher des Films ausgerichtet werden, die einen vorgegebenen Anfangsdurchmesser haben,
- durch die Löcher der Maske das oder die elektrisch leitenden Materialien, welche die Leiter-Inserts bilden, durch Sputtern oder Aufdampfen aufbringt.

11. Verfahren nach Anspruch 10, **dadurch gekennzeichnet, dass** der genannte vorgegebene Anfangsdurchmesser der Löcher des Films so ist, dass er die Verkleinerung dieses Anfangsdurchmessers bewirkt als Folge des Sputterns oder Aufdampfens, sodass die zweiten Enden der Inserts ebenfalls die Form von Spitzen haben.

12. Verfahren nach Anspruch 5, **dadurch gekennzeichnet, dass** das Abziehen der Stufe (d) durchgeführt wird durch chemisches Ätzen der Opferschicht.

13. Verfahren nach Anspruch 12, **dadurch gekennzeichnet, dass** das chemische Ätzen der Opferschicht durch einen Kapillareffekt vervollständigt wird.

14. Verfahren nach einem der Ansprüche 1 bis 13, **dadurch gekennzeichnet, dass** in der Stufe (d) des Abziehens mechanische Kräfte angewendet werden.

15. Verfahren nach einem der vorhergehenden Ansprüche, **dadurch gekennzeichnet, dass** die Stufen (a) und (b) darin bestehen, dass man:
- den isolierenden Film auf dem Substrat, das gegebenenfalls von einer Opferschicht bedeckt ist, deren Oberfläche noch nicht die Alveolen aufweist, abscheidet,
- eine Maske vorsieht, die mit Löchern entsprechend einem Motiv versehen ist, das der Verteilung der Inserts in dem Film entspricht,
- durch die Löcher der Maske hindurch ätzt einerseits den isolierenden Film und gegebenenfalls die Opferschicht, um darin Löcher zu erzeugen, und andererseits das Substrat, um darin die Alveolen zu erzeugen, und
- die Maske entfernt.

16. Verfahren nach Anspruch 15, **dadurch gekennzeichnet, dass** die Inserts durch Elektrolyse hergestellt werden, nachdem Löcher in den isolierenden Film geätzt worden sind und bevor die Maske entfernt wird, durch Abscheidung einer Schicht aus einem elektrisch leitenden Material, das sich an die geätzten Zonen des Substrats anpasst (anschmiegt).

17. Verfahren nach einem der Ansprüche 1 bis 16, **dadurch gekennzeichnet, dass** die ersten Enden (Spitzen) (29, 19, 81) der Leiter-Inserts (28, 18, 79) aus einem harten Material hergestellt sind.

18. Verfahren nach einem der Ansprüche 1 bis 17, **dadurch gekennzeichnet, dass** der genannte isolierende Film (26, 73) ein Film aus einem thermoplastischen Polymer ist.

19. Verfahren nach einem der Ansprüche 1 bis 18, **dadurch gekennzeichnet, dass** die in den isolierenden Film (26) eingeätzten Löcher (27) einen Querschnitt haben, der kleiner ist als der Querschnitt der Alveolen (24) auf der Oberfläche (21) des Substrats (20).
